# EUROPEAN PATENT SPECIFICATION

(11) **EP 3 963 013 B1**
(45) Date of publication and mention of the grant of the patent: **23.09.2026**
(21) Application number: 20723181.2
(22) Date of filing: 22.04.2020
(51) Int. Cl.: C09D 5/24, C08F 32/08, C08G 61/08, H01B 1/12, C08L 65/00, C08F 132/08, C09D 145/00, C08F 232/08, C08G 61/10, C09D 165/00

(54) **METHOD FOR FABRICATING A FILM**
VERFAHREN ZUR HERSTELLUNG EINER FOLIE
PROCÉDÉ POUR LA FABRICATION D'UN FILM

(30) Priority: 02.05.2019 FI 20195357
(43) Date of publication of application: 09.03.2022
(73) Proprietor: Turun Yliopisto, 20014 Turun yliopisto (FI)
(72) Inventor: YEWALE, Rahul Balu, 20014 Turun yliopisto (FI); SALOMÄKI, Mikko, 21250 Masku (FI); DAMLIN, Pia, 20660 Littoinen (FI); KVARNSTRÖM, Carita, 20100 Turku (FI)
(74) Representative: Papula Oy
(86) International application number: PCT/FI2020/050261
(87) International publication number: WO 2020/221958

(56) References cited:
- WO-A1-2013/184797
- WO-A1-2018/102709
- WO-A1-2019/211510
- US-A1- 2003 157 317
- HUANG X ET AL: "Surface plasmon study of electrochemically prepared polymers: Polyazulene", SYNTHETIC METALS, ELSEVIER SEQUOIA, LAUSANNE, CH, vol. 24, no. 3, 1 May 1988 (1988-05-01), pages 245 - 253, XP024158861, ISSN: 0379-6779, [retrieved on 19880501], DOI: 10.1016/0379-6779(88)90263-9
- R. B. YEWALE ET AL: "Vapor phase polymerized highly conducting PEDOT films as electrode and high capacitance material", 11TH ANNUAL MATSURF SEMINAR, 6 November 2017 (2017-11-06), Turku, Finland, XP055539895, Retrieved from the Internet <URL:https://www.utu.fi/en/sites/mats/Documents/MatSurfBooklet2017.pdf> [retrieved on 20190109]

## Description

### TECHNICAL FIELD

The present disclosure relates to a method for fabricating a film comprising at least one polymer layer. The present disclosure further relates to a film comprising at least one polymer layer. The present disclosure further relates to a device comprising the film and to the use of the film. The present disclosure further relates to a system for fabricating a film comprising at least one polymer layer.

### BACKGROUND

Oxidation of azulene monomer undergoes polymerization at 1- and 3- position to give 1,3-polyazulene. Polyazulene (PAz) is a conducting polymer with a high capacitance and redox behavior. PAz films may be produced by electrochemical, chemical and photochemical polymerization. Because of the electronic properties, conducting and redox behavior as well as the fast charge-discharge nature, PAz films may be useful in applications related to the field of electronics, antistatic coatings, dye-sensitized or organic solar cells, electrochemical transducers, electrochromic devices, electroluminescent devices, organic light emitting diodes (OLED's), and supercapacitors in the near future. In order to be suitable for the above mentioned applications, PAz films may need to be highly-organized, homogenous, transparent and thin. Of the current methods, electrochemical polymerization may produce non-uniform films and require a conducting electrode substrate limiting its fabrication only to electrode materials whereas oxidative chemical synthesis may give the material in powder or granular forms. Further casting or processing may not be possible due to the insoluble nature of PAz. Because the production of high-quality PAz films having the desired properties may be challenging with the current production methods, new approaches may be needed.

HUANG X et al. Surface plasmon study of electrochemically prepared polymers: polyazulene. In: Synthetic metal The Netherlands: Elsevier Sequoia, 1988-05-01, Vol. 24, 245-253, discloses the formation of a PAz film on a gold substrate using electropolymerization.

WO 2018/102709 A1 discloses a multilayer electrode comprising an electro-conductive layer and at least one protective layer.

WO 2013/184797 A1 discloses a ferroelectric device comprising substrate; a first electrode disposed on the substrate; a ferroelectric layer disposed on and in contact with the first electrode; and a second electrode disposed on and in contact with the ferroelectric layer, wherein at least one of the first electrode and the second electrode is an organic electrode comprising a doped electroconductive organic polymer, for example DMSO-doped PEDOT-PSS.

Yewale, R. B., et al., "Vapor phase polymerized highly conducting PEDOT films as electrode and high capacitance material", 11th Annual Matsurf Seminar, 6 November 2017, Turku, Finland, discloses a VPP method to produce a PEDOT film.

US 2003/157317 A1 discloses a transparent film-coated substrate, coating liquid for transparent film formation, and display device.

### SUMMARY

A method for fabricating a film comprising at least one polymer layer formed of PAz, or of a copolymer, wherein one of the monomers is azulene, or of any combination thereof, wherein the film is situated on at least one surface of a substrate is disclosed. The method may comprise the steps of:
a) forming an oxidant layer on a deposition surface by applying a solution comprising an oxidant on the deposition surface;
b) forming a polymer layer formed of PAz, a copolymer, wherein one of the monomers is azulene, or any combination thereof, by exposing the deposition surface to azulene monomer vapour at a polymerization temperature of 20 - 95 °C under atmospheric pressure,
wherein step a) precedes step b), and wherein, during step b), the temperature of the deposition surface differs from the polymerization temperature by 0 - 30 °C.

A film comprising at least one polymer layer formed of Paz, or of a copolymer, wherein one of the monomers is azulene, or of any combination thereof, wherein the film is situated on at least one surface of a substrate, wherein the total thickness of the film is 10 nm - 100 µm, the average roughness of the film is below 200 nm, and the sheet resistance of the film is 1 - 80 MΩ/□, is disclosed.

A film comprising at least one polymer layer formed of PAz, or of a copolymer, wherein one of the monomers is azulene, or of any combination thereof, wherein the film is situated on at least one surface of a substrate obtainable by a method described in the present application, wherein the average roughness of the film is below 200 nm, and the sheet resistance of the film is 1 - 80 MΩ/□, is disclosed.

A device comprising a film as defined in the present application is disclosed.

Use of the film as defined in the present application as an antistatic coating or an electrode in/of an electronic device, is disclosed.

A system for fabricating a film comprising at least one polymer layer formed of polyazulene, or of a copolymer, wherein one of the monomers is azulene, or of any combination thereof, wherein the film is situated on at least one surface of a substrate, is disclosed. The system may comprise:
a) an oxidant unit configured to apply a solution comprising an oxidant on a deposition surface for forming an oxidant layer on the deposition surface; and
b) a chamber configured to expose the deposition surface to at least azulene monomer vapour at a polymerization temperature of 20 - 95 °C under atmospheric pressure for forming a polymer layer formed of polyazulene, or of a copolymer, wherein one of the monomers is azulene, or of any combination thereof,
wherein the oxidant unit precedes the chamber, and wherein, in the chamber, the temperature of the deposition surface is configured to differ from the polymerization temperature by 0 - 30 °C.

### BRIEF DESCRIPTION OF THE DRAWINGS

The accompanying drawings, which are included to provide a further understanding of the embodiments and constitute a part of this specification, illustrate various embodiments. In the drawings:
Fig. 1 is a schematic illustration of a film situated on a surface of a substrate according to one embodiment of the present invention;
Fig. 2 illustrates a vapour phase polymerization cell for carrying out the vapour phase polymerization;
Fig. 3 illustrates a continuous set up for carrying out continuous vapour phase polymerization for flexible substrates;
Fig. 4 illustrates a continuous set up for carrying out continuous vapour phase polymerization for rigid substrates;
Fig. 5 illustrates a scaled up vapour phase polymerization cell for carrying out the vapour phase polymerization in a larger scale;
Fig. 6 describes changes in roughness, sheet resistance, and conductivity of PAz films prepared with 240 mM CuCl₂; and
Fig. 7 illustrates AFM images of 1L PAz, 3L PAz and 6L PAz films with 50 by 50 µm and 10 by 10 µm sizes.

### DETAILED DESCRIPTION

The present application relates to a method for fabricating a film comprising at least one polymer layer formed of polyazulene (PAz), or of a copolymer, wherein one of the monomers is azulene, or of any combination thereof, wherein the film is situated on at least one surface of a substrate, wherein the method comprises the steps of:
a) forming an oxidant layer on a deposition surface by applying a solution comprising an oxidant on the deposition surface;
b) forming a polymer layer formed of PAz, or of a copolymer, wherein one of the monomers is azulene, or of any combination thereof, by exposing the deposition surface to at least azulene monomer vapour at a polymerization temperature of 20 - 95 °C under atmospheric pressure,
wherein step a) precedes step b), and wherein, during step b), the temperature of the deposition surface differs from the polymerization temperature by 0 - 30 °C.

The present application further relates to a system for fabricating a film comprising at least one polymer layer formed of polyazulene, or of a copolymer, wherein one of the monomers is azulene, or of any combination thereof, wherein the film is situated on at least one surface of a substrate, wherein the system comprises:
a) an oxidant unit configured to apply a solution comprising an oxidant on a deposition surface for forming an oxidant layer on the deposition surface; and
b) a chamber configured to expose the deposition surface to at least azulene monomer vapour at a polymerization temperature of 20 - 95 °C under atmospheric pressure for forming a polymer layer formed of polyazulene, or of a copolymer, wherein one of the monomers is azulene, or of any combination thereof,
wherein the oxidant unit precedes the chamber, and wherein, in the chamber, the temperature of the deposition surface is configured to differ from the polymerization temperature by 0 - 30 °C.

In the context of this specification the term "polymerization temperature" may refer to the temperature of the monomer vapour(s) during the polymerization step b). Polymerization temperature may also refer to the temperature of the reaction chamber or cell, inside of which the polymerization is carried out.

In one embodiment, in step b), the deposition surface is exposed to at least azulene monomer vapour and at least one further monomer vapour. In one embodiment, in step b), the deposition surface is exposed to at least azulene monomer vapour and at least one further monomer vapour selected from a group consisting of 3,4-ethylenedioxythiophene (EDOT), pyrrole, aniline, thiophene, and phenylene. In one embodiment, the at least one further monomer vapour is selected from the following: 3,4-ethylenedioxythiophene (EDOT), pyrrole, aniline, thiophene, phenylene, furans, ethylene, tetrafluoroethylene, vinyl chloride, propylene, methyl methacrylate, methyl acrylate, vinyl acetate, ethylene vinyl acetate, styrene, 1,3-butadiene, isoprene(2-methyl-1,3-butadiene), chloroprene(2-chloro-1,3-butadiene), isobutylene(methylpropene), polyethylene (PE), polypropylene (PP), polymethylpentene (PMP), polybutene-1 (PB-1); polyolefin elastomers (POE): polyisobutylene (PIB), ethylene propylene rubber (EPR), ethylene propylene diene monomer (M-class) rubber (EPDM rubber) and any type of polymer produced from a simple olefin as a monomer, cyclic olefin, vinyl ether, allyl ether, vinyl ester, allyl ester. Those monomers, which cannot be converted into a vapour, can be mixed with the solution comprising an oxidant and applied on the deposition surface during step a). In one embodiment, step a) comprises applying a solution comprising or consisting of an oxidant and at least one further monomer.

The present application further relates to a film comprising at least one polymer layer formed of PAz, or of a copolymer, wherein one of the monomers is azulene, or of any combination thereof, wherein the film is situated on at least one surface of a substrate, wherein the total thickness of the film is 10 nm - 100 µm, the average roughness of the film is below 200 nm, and the sheet resistance of the film is 1 - 80 MΩ/□.

In one embodiment, the total thickness of the film is 20 nm - 50 µm, or 50 nm - 10 µm, or 100 nm - 1 µm, or 200 nm - 500 nm.

The present application further relates to a film comprising at least one polymer layer formed of PAz, or of a copolymer, wherein one of the monomers is azulene, or of any combination thereof, wherein the film is situated on at least one surface of a substrate, obtainable by the method of the present application, wherein the average roughness of the film is below 200 nm, and the sheet resistance of the film is 1 - 80 MΩ/□.

In one embodiment, the method comprises repeating the step a) and b) one or more times.

In one embodiment, the method is carried out as a batch process. I.e. one film can be prepared at one go, e.g. in a reaction chamber or a cell, wherein the different method steps can be carried out. In one embodiment, the method is carried out as a continuous process. I.e. the substrate can be moved from one method step into the other without interruptions. E.g. being first coated with the oxidant and then exposed to monomer vapour(s). In a continuous process, several films may be prepared simultaneously.

In one embodiment, the film has a rigid structure. In one embodiment, the film is flexible. In one embodiment, the film may be rolled up.

In one embodiment, at least one catalyst and/or at least one catalyst additive are/is used in step b). In one embodiment, the at least one catalyst and/or catalyst additive is selected from the following: Ziegler-Natta catalysts, AlCl₃, TiCl₃, cerium ammonium nitrate, cerium tosylate, Fe(III)tosylateisalsousedasanoxidant, pyridine, p-toluenesulphonicacid(p-TSA), diethyleneglycol(DEG), molybdophosphoric acid, molybdo-2-vanadophosphoricacid, poly(styrenesulfonate)(PSS), Fe(III)alkylbenzenesulfonates, iodine, bromine, pyrocatechovoilet, benzenesulfonicacid(BSA), p-toluenesulfonicacid(TSA), dodecylbenzenesulfonicacid(DBSA), butylbenzenesulfonicacid(BBSA), glycerol, trialkylaluminum-free modified methylaluminoxane, TEMPO ((2,2,6,6-Tetramethylpiperidin-1-yl)oxyl or (2,2,6,6-tetramethylpiperidin-1-yl)oxidanyl), peroxides, chloride or iodide of Ti, V, Zr, Cr, W, Co and aluminum (Mg or Li) alkyl TiCl₄ with alkyl aluminium compounds in hydrocarbon solvent, titanium supported on magnesium salts, VOCl₃, VCl₄, or VO (OR)₃, with aluminum alkyls RAlCl₂, transitions metal (Zr, Ti or Hf) sandwiched between cyclopentadienyl rings, Cr, Mo, Co or Ni supported on alumina, silica, zirconia and activated carbon, Cr/SiO₂, Zr/Al₂O₃ and Ti/MgO, supported chromium oxide, bis(arene)Cr0, chromium oxides supported on silica, alumina or titania.

In one embodiment, step b) is continued until the thickness of the polymer layer is at least 10 - 100 nm, or 20 - 90 nm, or 30 - 80 nm, or 40 - 60 nm. For certain applications it may be useful to have a thicker film i.e. several layers of polymer layers, whereas for other applications a thinner film with less layers may be useful. The number of layers i.e. the thickness of the film may affect the active material content and configuration at micro or nano level, which may affect the film properties such as conductivity, capacitance, sheet resistance, band gap, active surface area, and transparency.

In the context of this specification, the term "deposition surface" may refer to a surface of the substrate as such or to a surface covered with an oxidant layer. The "deposition surface" may further refer to the surface covered with a polymer layer, which lies on top of the oxidant layer or the substrate. It may further refer to a surface covered with sequential layers of the oxidant and/or polymer layers, wherein the first layer on the surface of the substrate is the oxidant layer followed by the polymer layer, and so on. The "deposition surface" thus changes during the (deposition) process, when chemicals are applied onto the surface.

The term "film" should be understood in this specification, unless otherwise stated, as referring to a structure having its lateral dimensions substantially larger than its thickness. In that sense, a film may be considered as being a "thin" structure.

The expression that the film is "situated on" the surface of the substrate should be understood in this specification, unless otherwise stated, as meaning that the film is formed to lie on or upon the substrate or is being at least partly embedded therein. The substrate may serve as a carrier or support structure for the film. The substrate can be changed and the material of the substrate can vary according to the application to which the film is to be used. In one embodiment, the substrate is rigid. In one embodiment, the substrate is flexible, bendable, and/or can be rolled up.

In one embodiment, the polymer layer is a 1,3-polyazulene layer. In one embodiment, the film comprises at least one 1,3-polyazulene layer. In one embodiment, the film consists of at least one polymer layer formed of PAz, or of a copolymer, wherein one of the monomers is azulene, or of any combination thereof. In one embodiment, the film consists of one or more polymer layers formed of PAz, or of a copolymer, wherein one of the monomers is azulene, or of any combination thereof. In one embodiment, the film consists of at least one polymer layer formed of PAz, or of a copolymer, wherein one of the monomers is azulene, or of any combination thereof, and at least one oxidant layer. In one embodiment, the film consists of one or more polymer layers formed of PAz, or of a copolymer, wherein one of the monomers is azulene, or of any combination thereof, and one or more oxidant layers.

In one embodiment, the polymer layer is formed at least on one side of the substrate. In one embodiment, the polymer layer is formed on a top and a bottom side of the substrate.

In one embodiment, step b) is continued for 1 - 20 minutes, or 2 - 16 minutes, or 4 - 8 minutes. The polymerization time may affect the thickness of the polymer layer formed of PAz, or of a copolymer, wherein one of the monomers is azulene, or of any combination thereof. If the polymerization is continued for a longer time, the polymer layer may be thicker. It may also be possible that after a certain time period the layer will no longer get thicker although the polymerization is continued. This may be due to the fact that once the deposition surface covered with an oxidant layer is completely occupied by polymerized polymer, the monomer is unable to reach the oxidant even if polymerization is continued for a longer time. It may only deposit monomer as such but it will not be polymerized. Further, the deposited non-polymerized monomer may be rinsed away during the washing of the film leaving only polymerized film behind.

In one embodiment, the polymer layer is formed on the deposition surface by atmospheric pressure vapour phase polymerization (VPP). VPP is a polymerization technique where only the monomer is converted into vapour phase. The VPP carried out in atmospheric pressure has the added utility of being easy to control. It may not need pressure control or sophisticated device or vacuum oven. The method may be used also for production of large area films.

In one embodiment, the VPP is carried out in a reaction chamber or cell. In one embodiment, the temperature of the reaction chamber or cell is controlled. In one embodiment, the temperature of the reaction chamber or cell is controlled with thermostat baths.

In one embodiment, during step b), the temperature of the deposition surface is 25 - 75 °C, or 30 - 60 °C, or 35 - 65 °C, 40 - 50 °C, or 45 - 55 °C.

In one embodiment, during step b), the polymerization temperature is 25 - 90 °C, or 35 - 85 °C, or 40 - 80 °C, or 45 - 75 °C, or 50 - 70 °C, or 55 - 65 °C. The use of a low polymerization temperature has the added utility of saving costs as less electricity is used. It may also be suitable for temperature sensitive substrates, such as biomolecule treated substrates or plastic and other delicate substrates.

In one embodiment, during step b), the temperature of the deposition surface differs from the polymerization temperature by 0 - 30 °C, or 1 - 25 °C, or 5 - 20 °C, or 10 - 15 °C.

In one embodiment, during step b), the temperature of the deposition surface is 0 - 30 °C, or 1 - 25 °C, or 5 - 20 °C, or 10 - 15 °C lower than the polymerization temperature, or 0 - 20 °C, or 1 - 15 °C, or 5 - 10 °C higher than the polymerization temperature. In one embodiment, during step b), the temperature of the deposition surface is 0 - 30 °C, or 1 - 25 °C, or 2 - 25 °C, or 3 - 25 °C, or 4 - 20 °C, or 5 - 20 °C, or 10 - 15 °C lower than the polymerization temperature, or 0 - 20 °C, or 1 - 15 °C, or 2 - 15 °C, or 3 - 15 °C, or 4 - 10 °C, or 5 - 10 °C higher than the polymerization temperature.

The temperature of the deposition surface may affect the sheet resistance of the film. It may increase or decrease the sheet resistance. Further, it may affect the stability of the film configuration and in some cases avoid fracture due to stress during washing. Decrease in sheet resistance after temperature treatment may mean either that the doping level is decreasing or that polymer chain structures are reorganizing or breaking. In one embodiment, the temperature of the deposition surface is at least, or above, 0 °C. In one embodiment, the temperature of the deposition surface is at least, or above, room temperature.

In one embodiment the polymerization temperature is 20 - 95 °C and the temperature of the deposition surface is 25 - 75 °C, the polymerization temperature is 25 - 90 °C and the temperature of the deposition surface is 25 - 75 °C, or the polymerization temperature is 35 - 85 °C and the temperature of the deposition surface is 30 - 70 °C, or the polymerization temperature is 40 - 80 °C and the temperature of the deposition surface is 35 - 65 °C, or the polymerization temperature is 45 - 75 °C and temperature of the deposition surface is 40 - 50 °C, or the polymerization temperature is 50 - 60 °C and temperature of the deposition surface is 45 - 55 °C.

In one embodiment, the cell or the reaction chamber contains a saturated amount of monomer vapour(s). The amount may depend on the size of the cell or the chamber.

In one embodiment, the oxidant is selected from a group consisting of iron(II), iron (III), cerium (IV) and copper(II) salts. In one embodiment, the oxidant is selected from a group consisting of FETOS, FeCl₃, CuCl₂, CuBr₂, and Fe(OTf)₃. The oxidizing strength of the oxidants may vary. The film structure and polymer configuration may change depending on which oxidant is used. In one embodiment, the CuCl₂ oxidant provides films of high quality. In one embodiment, the Fe(OTf)₃ oxidant provides films of high quality. In one embodiment, the FETOS oxidant provides films of high quality. In one embodiment, the CuBr₂ oxidant provides films of high quality.

In one embodiment, the concentration of the solution comprising the oxidant is 60 - 500 mM, or 70 - 480 mM, or 120 - 320 mM, or 180 - 240 mM. The solvent in the solution comprising the oxidant may be selected from a group consisting of organic solvents such as n-butanol, methyl alcohol, 2-butyl alcohol, n-propyl alcohol, iso-propanol, ethyl cellosolve, ethyl alcohol, ethyl acetate, acetonitrile and methyl ethyl ketone and mixtures thereof. The purpose of the oxidant is to deprotonate the monomer and initiate the polymerization. In one embodiment, the solution consists of a solvent and an oxidant. In one embodiment, the oxidant layer is dried before polymerization. By drying the oxidant layer before polymerization, one is able to remove traces of solvents before proceeding into the polymerization step. In one embodiment, the polymerization reaction is a gas-solid reaction having interface.

In one embodiment, the solution comprising the oxidant is spin coated on the deposition surface. In one embodiment, the solution comprising the oxidant is spin coated on the deposition surface at 1000 - 2800 rpm for 20 - 90 s. In one embodiment, the solution comprising the oxidant is spin coated on the deposition surface at 1200 - 2600 rpm, or 1400 - 2400 rpm or 1600 - 2200 rpm, or 1800 - 2000 rpm for 30 - 80 s, or 40 - 70 s, or 50 - 60 s. In one embodiment, the oxidant coated deposition surface is dried before step b). In one embodiment, the oxidant coated deposition surface is dried on a hot plate at a temperature of 70 - 110 °C for 10 - 150 s, e.g. at 90 °C for 90 s.

In one embodiment, the method comprises the step of cleaning the deposition surface before step a). In one embodiment, the substrate may be cleaned by ultra-sonication with a solvent. In one embodiment, the solvent for the ultra-sonication may be selected from the group consisting of organic solvents. In one embodiment, the solvent for the ultra-sonication is selected from a group consisting of acetone, EtOH, water and mixtures thereof.

In one embodiment, the cleaned deposition surface may be dipped into a hot solution. In one embodiment, the cleaned deposition surface may be dipped in hot solution of H₂O:NH₄OH (25 %):H₂O₂ (30 %) as 5:1:1 volume ratio at a temperature of 50 - 100 °C, e.g. 85 °C. The cleaning has the added utility of removing any organic impurities left behind on the surface. In one embodiment, an oxygen plasma treatment may follow. Oxygen plasma treatment refers to a plasma treatment where oxygen is introduced to a plasma chamber. The oxygen plasma treatment has the added utility to further clean the substrate. Oxygen is the most common gas used in plasma cleaning technology due to its low cost and wide availability.

In one embodiment, the method comprises, after step b), the step of annealing the film at a temperature of 60 - 100 °C. In one embodiment, the temperature of the annealing step is 70 - 90 °C or about 80 °C. In one embodiment, annealing of the film is continued for 140 - 40 s, or 50 - 120 s, or 60 - 90 s e.g. for 120 s. Annealing may be done on a hot plate or in an oven. In one embodiment, the system comprises a heating unit configured to anneal the film at a temperature of 60 - 100 °C.

In one embodiment, after annealing, the film is cooled to room temperature. The film can be annealed to avoid stress fracture of the film during the washing step. In one embodiment, the annealed and cooled film is washed. In one embodiment, the washing comprises dip rinsing the film with MeCN and/or with EtOH. The washing has the added utility of removing unreacted oxidant, monomer and any other impurities that may decrease the conductance. The solvent used may affect the sheet resistance of the film. The sheet resistance may be reduced e.g. due to water traces present in the solvent. In one embodiment, after washing, the film is dried under dry nitrogen gas stream.

In one embodiment, the substrate is non-conductive. In one embodiment, the substrate comprises or consists of glass, rubber, polymer, or any combination of these. In one embodiment, the glass may be a microscope glass slide or fluorine-doped tin oxide (FTO) glass or indium tin oxide (ITO) coated glass. In one embodiment, the non-conductive substrate comprises or consists of a polymer. The polymer may be polyethylene terephthalate (PET). In one embodiment, the rubber is selected from a group consisting of ethylene propylene rubber (EPR) and ethylene propylene diene monomer (M-class) rubber (EPDM rubber).

In one embodiment, thickness of the substrate is 5 µm - 2 cm. The thickness of the substrate may vary depending on the purpose of the use of the film or the material of the substrate.

The expression that the substrate is "non-conductive" should be understood in this specification, unless otherwise stated, as meaning that the substrate has a sheet resistance of 10 Mohms/square (M/□) or higher.

In one embodiment, the substrate is conductive e.g. fluorine-doped tin oxide (FTO) glass or Indium tin oxide (ITO) coated glass or Gold(Au)coated substrate or Silver (Ag) coated substrate or silicon. Depending on the application, a conductive or non-conductive substrate may be useful.

The roughness of the film, sometimes also referred to as surface roughness, is a measure of the deviations in the direction of the normal vector of a real surface from its ideal form. If the deviations are large, the surface is rough; if the deviations are small, the surface is smooth.

In one embodiment, the average roughness (Rₐ) of the film is below 200 nm, or below 150 nm, or below 100 nm, or below 80 nm, or below 50 nm, or below 25 nm, or below 15 nm, or below 10 nm.

Roughness average values of the PAz films are obtained from the AFM images by using WSXM 5 software. The roughness average is the mean of the difference, in absolute value, between the average height and the height of each single point of the sample. This number varies with the interval range. It shows how uniform or rough the PAz film is. It may be calculated with the following equation (1) $r . a = \frac{{\sum }_{i , j} \left|{a}_{i , j}-\left〈a\right〉\right|}{N}$ wherein
r.a stands for rougness average,
< a > is the average height,
aij is the height at each single point of the sample,
i and j denotes the position of single point (entries) on two dimensional surface; and
N is the number of "aij" points considered on the surface.

Root mean square (RMS) of the roughness of the films are obtained from the AFM images by using WSXM 5 software. It may be calculated with the following equation (2) $rms = \sqrt{\frac{{\sum }_{ij} {\left({a}_{ij}-\left〈a\right〉\right)}^{2}}{N}}$

This number varies with the interval range. Minimum value: minimum value of the height of the interval of interest. Maximum value: maximum value of the height of the interval of interest.

In one embodiment, the roughness of the film is measured before annealing and washing steps. This may be useful to check how these steps affect the roughness of the film since it is an important property of the film.

A smooth film has the added utility that the conductivity and transmittance thereof may remain even over the whole surface of the film.

In one embodiment, the transmittance of the film is 10 - 95%, or 20 - 85%, or 30 - 75%. In one embodiment, the transmittance of the film is measured at 300 - 1100 nm, or at 550 - 1100 nm, or at 550 nm.

Agilent 8453 spectrometer can be used to record the UV-Vis spectra. The % Transmittance (%T) is calculated from the absorbance data by using following equation (3), $\left(%T\right) = \left({10}^{∧}\left(-Abs\right)\right) * 100$

In one embodiment, the areal capacitance of the film is 0 - 10 mF/cm², or 0.01 - 9 mF/cm², or 0.05 - 8 mF/cm², or 0.2 - 7 mF/cm², or 1 - 5 mF/cm², or 2 - 4 mF/cm². In one embodiment, the areal capacitance of the film is 0 - 25 mF/cm², or 0.01 - 15 mF/cm², or 0.05 - 10 mF/cm², or 0.2 - 7 mF/cm², or 1 - 5 mF/cm², or 2 - 4 mF/cm².

In one embodiment, the volumetric capacitance of the film is 200 - 2000 F/cm³, or 250 - 1500 F/cm³, or 300 - 1200 F/cm³, or 500 - 1000 F/cm³, or 600 - 800 F/cm³. In one embodiment, the volumetric capacitance of the film is 5000 - 18000 F/cm³, or 6000 - 17500 F/cm³, or 7000 - 17000 F/cm³.

In one embodiment, the areal and volumetric capacitance values are determined by electrochemical characterization with cyclic voltammetry (CV). The charge (Q) is calculated by integration of the cyclic voltammogram in the potential range -0.25 V to 0.9 V in the Origin software which is further processed by using equations (4) and (5) to obtain capacitance values: $Areal capacitance , {C}_{A} = Q / \left(ΔV*A\right)$ $Volumetric Capacitance , {C}_{V} = Q / \left(ΔV*V\right)$ Where, 'ΔV' is the potential window, 'A' is the area and 'V' is the volume of working electrode. (Note: All solutions were purged with dry nitrogen gas for 15 min prior to measurement).

In one embodiment, the conductivity of the film is 0 - 3 S.cm, or 0.01 - 2 S.cm, or 0.05 - 1.5 S.cm, or 0.1 - 1.0 S.cm, or 0.3 - 0.8 S.cm, or 0.4 - 0.6 S.cm. The conductivity may be measured before or after the washing of the film. After the washing the conductivity value may be higher or lower than before the washing step. At low polymerization temperatures, the conductivities are lower before the washing step. At high polymerization temperatures, the conductivities are lower after the washing step.

In one embodiment, the sheet resistance of the film is 1 - 80 MΩ/□, or 2 - 70 MΩ/□, or 5 - 50 MΩ/□, or 10 - 40 MΩ/□, or 15 - 30 MΩ/□.In one embodiment, the sheet resistance of the film is 0.01 - 2 MΩ/□, or 0.05 - 1.5 MΩ/□, or 0.08 - 1.1 MΩ/□, or 0.2 - 1.1 MΩ/□, or 0.6 - 1 MΩ/□. The sheet resistance may be measured before or after the washing of the film. After the washing the sheet resistance value may be higher or lower than before the washing step. At low polymerization temperatures, the sheet resistance values are lower after the washing step. At high polymerization temperatures, the sheet resistance values are higher after the washing step.

In one embodiment, the sheet resistance is measured before annealing and washing steps. This may be useful to check how these steps affect the resistance of the film.

Jandel model RM3000+ with cylindrical four point probe head was used to obtain sheet resistance (rₛₕₑₑₜ) values for the PAz films. The specific resistance (r) of the film is obtained by multiplying sheet resistance with film thickness (d), equation (6): $r = {r}_{sheet} d$

The conductivity (s) of the film is obtained according to equation (7) $s = 1 / r$

The present application further relates to a device comprising a film of the present application.

In one embodiment, the device is an organic electrochemical transistor, an electrochemical transducer, an electrochromic device, an electroluminescent device, an electroluminescent display, an organic capacitor, a supercapacitor, a sensor, a biosensor, an energy harvesting device, an antistatic material, a photovoltaic device, a storage device or a thermoelectric device.

The present application further relates to the use of the film as an antistatic coating or an electrode in/of an electronic device.

The method described in the current application has the added utility of producing highly organized, transparent, homogenous, multilayer thin films. Further, the method described in the current application has the added utility of being low cost, simple and fast due to atmospheric pressure controlled polymerization, short reaction time, low temperature and low monomer loading.

The method described in the current application has the added utility of allowing layer by layer preparation of the film which may be useful in different applications. The method described in the current application has the added utility of allowing preparation of flexible thin films on plastic materials which may be used in bendable electronics. Further, the method allows the preparation of thin films of nanometre to micrometre scale.

The method described in the current application has the added utility of being suitable for the preparation of films with different properties, e.g. conductivities and roughness values, being thus useful for a variety of applications.

### EXAMPLES

Reference will now be made in detail to various embodiments, an example of which is illustrated in the accompanying drawing.

The description below discloses some embodiments in such a detail that a person skilled in the art is able to utilize the embodiments based on the disclosure. Not all steps or features of the embodiments are discussed in detail, as many of the steps or features will be obvious for the person skilled in the art based on this specification.

For reasons of simplicity, item numbers will be maintained in the following exemplary embodiments in the case of repeating components.

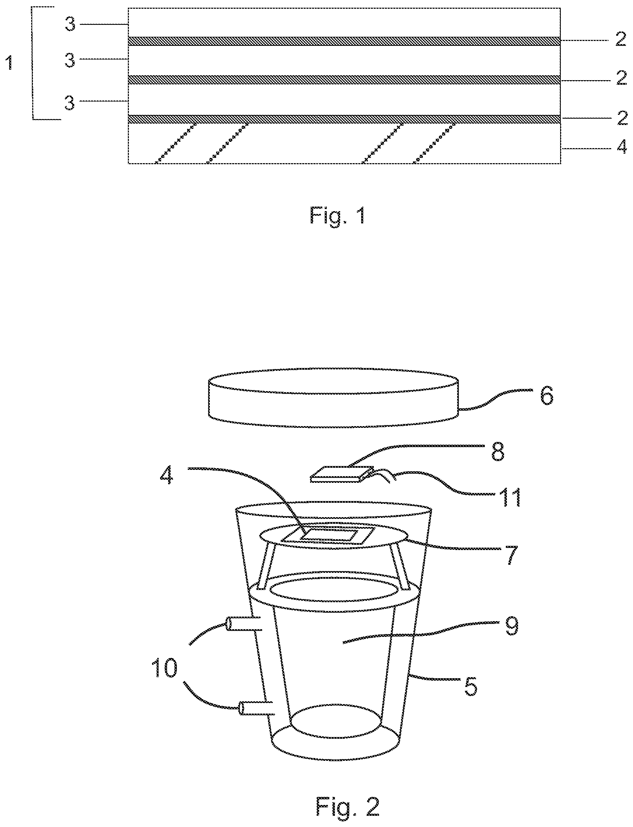

Fig. 1 illustrates a film comprising PAz layers prepared by VPP according to one embodiment described in the present application. The film 1 may comprise one or more layers of the oxidant 2 and one or more polymer layers 3, wherein the layers are situated on a surface of a substrate 4 one upon the other so that the first layer on top of the substrate is the oxidant layer. Oxidant layer may also be washed away during the production method, i.e. the film may not necessarily contain (a) oxidant(s) layer(s).

Fig. 2 illustrates a VPP chamber for carrying out VPP according to one embodiment described in the present application. The polymerization or reaction chamber 5 comprises a stand 7 for the substrate 4 and for the metal block 8. Thermostatic baths 10 are attached to the polymerization chamber 5 to keep the temperature of the monomer vapour(s) 9 at the polymerization temperature. The thermostatic bath 11 is attached to the metal block 8 to keep the temperature of the substrate 4 and thus the temperature of the deposition surface at the controlled predetermined temperature. The polymerization chamber 5 comprises a lid 6 which is used to close the polymerization chamber 5.

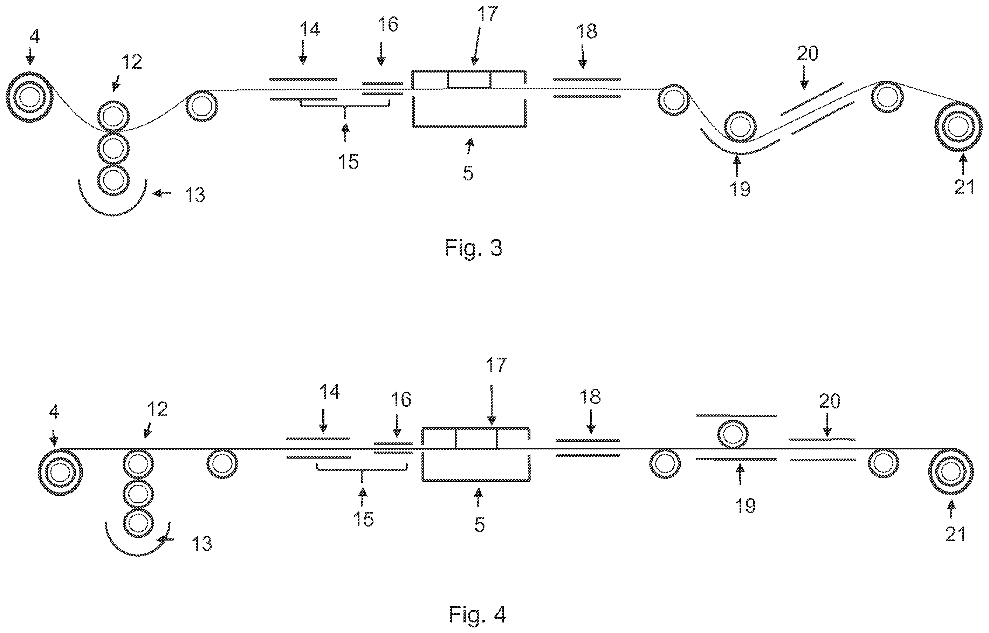

Figures 3 and 4 illustrate the set ups for a continuous VPP process for flexible (Fig. 3) and rigid (Fig. 4) substrates according to one embodiment described in the present application. Solution comprising the oxidant 13 is deposited on the substrate 4 by roll to roll technique 12, followed by drying of the oxidant 14 and preheating 16 in an oven or with a heater 15. In the next step, the substrate 4 covered with an oxidant is exposed to monomer vapour(s) in the polymerization chamber or cell 5. The speed of the rollers determines the time substrate spends inside the chamber. Temperature of the substrate or the deposition surface is controlled with a heater/temperature controller 17. Next, the film is annealed 18, followed by the washing of the solvent 19. Finally, the film is dried (with nitrogen gas) 20 and the substrate covered with a film 21 is obtained.

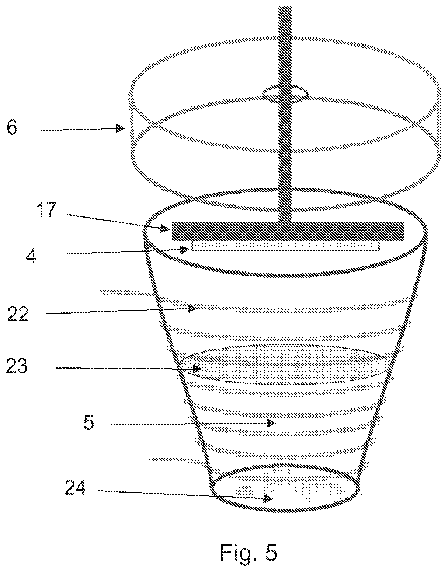

Fig. 5 illustrates a scaled up VPP chamber for carrying out VPP according to one embodiment described in the present application. The polymerization chamber 5 includes the substrate 4 and a heater/temperature controller 17 for the substrate. Heating coils 22 are used to vaporize the monomer and heat it to the polymerization temperature. The chamber further includes a vapour homogenizer 23 and an adjustable lid 6 to close the polymerization chamber 5.

### Example 1 - Preparation of a film comprising polymer layers

A substrate was cleaned by ultra-sonication with acetone, water and EtOH, respectively in each for 5 min. The cleaned glass substrate was dipped in hot solution (80 °C) of H₂O:NH₄OH (25 %):H₂O₂ (30 %) as 5:1:1 volume ratio for 5 min to remove any organic impurities left behind on the surface. The substrate was then cleaned by oxygen plasma treatment for 3 min. The 60 mM solution comprising the oxidant was prepared using n-butanol as a solvent. 80 µl of the solution comprising the oxidant was spin coated on the substrate at 2400 rpm for 60 s. The oxidant coated substrate was dried on a hot plate at 90 °C for 90 s. The dried substrate was immediately transferred to a preheated cell (Figure 2) containing azulene monomer at 56 °C in such a way that the coated surface faced down towards the vapors. Polymerization was carried out for 4 min. Annealing of the film was done after polymerization on a hot plate at 90 °C for 120 s. After annealing, the film was let to cool to room temperature and dip rinsed thoroughly in MeCN to remove unreacted oxidant, monomer and any other impurities. After washing, the film was dried under dry nitrogen gas stream. The procedure was repeated from the spin coating step one or more times to prepare multiple layers of PAz on the substrate. The temperature of the cell was controlled by thermostat baths.

The procedure described above was repeated with several different oxidants and oxidant concentrations to produce single- or multilayer PAz films with different properties.

The same procedure may be used for different substrates. Further, the step of annealing may, in some cases, be left out.

### EXAMPLE 2 - Preparation of a film comprising polymer layers

The procedure described above for example 1 was followed but the polymer layer was formed of a copolymer, wherein one of the monomers was azulene and the additional monomer was 3,4-ethylenedioxythiophene. Both monomers were exposed simultaneously to the deposition surface. The parameters during the example as well as the results are discussed below in relation to Table 4.

### Results

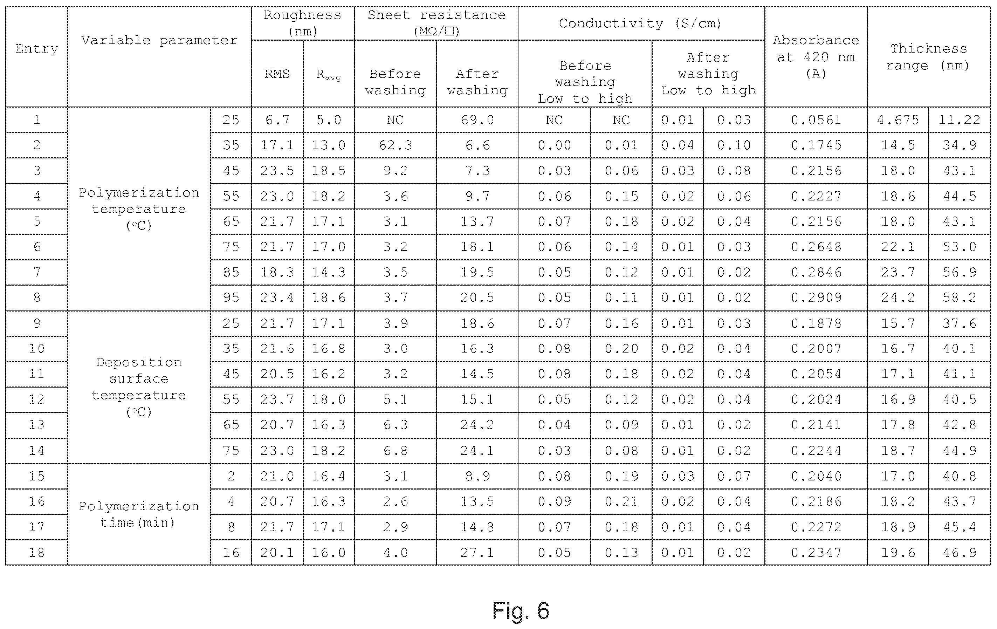

Fig. 6 describes changes in roughness, sheet resistance, and conductivity of PAz films prepared by varying first the polymerization temperatures while keeping the deposition surface temperature (about room temperature) and polymerization time (4 minutes) constant, and then varying the deposition surface temperatures while keeping the polymerization temperature (55 °C) and polymerization time (4 minutes) constant, and finally, varying the polymerization time (from 2 to 16 minutes) while keeping the polymerization temperature (55 °C) and deposition surface temperature (about room temperature) constant. All the films presented in Fig. 6 were prepared by using 80 µl of 240 mM oxidant solution. The oxidant was spin coated on the substrate with a spin coating speed of 2400 rpm. The oxidant layer was dried at 90 °C for 90 s. No annealing was performed. The films were washed two times with acetonitrile and dried under nitrogen gas stream. In Fig. 6, "NC" denotes non conducting.

Table 1 describes the changes in areal and volumetric capacitance and charge values for one layer (1L), three layers (3L) and six layers (6L) PAz films prepared using different concentrations of or FETOS oxidants. All the films were prepared using 80 ul of oxidant solution. The oxidant was spin coated on the substrate with a spin coating speed of 2400 rpm. The oxidant layer was dried at 90 °C for 90 s. Polymerization time per layer was 4 minutes and polymerization temperature was 55 °C. Annealing was performed for all the other films except entries 1 to 6. The films were washed two times with acetonitrile and dried under nitrogen gas stream. Temperature of the deposition surface was at about room temperature.

**Table 1. Changes in areal and volumetric capacitance values and charges of 1L, 3L and 6L PAz films.**

| Entry | Scan rate (mV/s) | Layers | Oxidant | Charge (mC) | Areal Capacitance MF/cm² | Volumetric Capacitance | |
|---|---|---|---|---|---|---|---|
| | | | | | | Range (F/cm³) | |
| 1 | 20 | 1L | (240 mM) | 1.58 | 1.22 | 304 | 608 |
| 2 | 200 | | | 1.29 | 0.99 | 248 | 496 |
| 3 | 20 | 3L | | 5.13 | 3.95 | 493 | 987 |
| 4 | 200 | | | 4.88 | 3.76 | 469 | 939 |
| 5 | 20 | 6L | | 11.17 | 8.60 | 781 | 1910 |
| 6 | 200 | | | 8.51 | 6.55 | 595 | 1455 |
| 7 | 20 | 1L | CuCl₂ (240 mM) | 1.82 | 1.40 | 350 | 700 |
| 8 | 200 | | | 1.64 | 1.26 | 316 | 631 |
| 9 | 20 | 3L | | 5.88 | 4.52 | 566 | 1131 |
| 10 | 200 | | | 5.05 | 3.89 | 486 | 972 |
| 11 | 20 | 1L | FETOS (240 mM) | 2.92 | 2.25 | n.a | n.a |
| 12 | 200 | | | 0.25 | 0.19 | n.a | n.a |
| 13 | 20 | 3L | | 3.75 | 2.89 | n.a | n.a |
| 14 | 200 | | | 0.37 | 0.29 | n.a | n.a |
| 15 | 20 | 1L | CuCl₂ (180 mM) | 1.66 | 1.28 | 394 | 946 |
| 16 | 200 | | | 1.1 | 0.85 | 261 | 627 |
| 17 | 20 | 3L | | 4.16 | 3.20 | 420 | 1007 |
| 18 | 200 | | | 3.69 | 2.84 | 373 | 893 |
| 19 | 20 | 1L | FETOS (180 mM) | 4.07 | 3.13 | n.a | n.a |
| 20 | 200 | | | 0.24 | 0.18 | n.a | n.a |
| 21 | 20 | 3L | | 9.08 | 6.99 | n.a | n.a |
| 22 | 200 | | | 0.91 | 0.70 | n.a | n.a |
| 23 | 20 | 1L | CuCl₂ (120 mM) | 1.09 | 0.84 | n.a | n.a |
| 24 | 200 | | | 0.60 | 0.46 | n.a | n.a |
| 25 | 20 | 3L | | 2.69 | 2.07 | n.a | n.a |
| 26 | 200 | | | 2.17 | 1.67 | n.a | n.a |
| 27 | 20 | 1L | FETOS (120 mM) | 2.57 | 1.98 | n.a | n.a |
| 28 | 200 | | | 0.34 | 0.26 | n.a | n.a |
| 29 | 20 | 3L | | 5.28 | 4.06 | n.a | n.a |
| 30 | 200 | | | 0.45 | 0.34 | n.a | n.a |
| 31 | 20 | 1L | CuBr₂ (120 mM) | 0.62 | 0.48 | n.a | n.a |
| 32 | 200 | | | 0.15 | 0.12 | n.a | n.a |
| 33 | 20 | 3L | | 0.91 | 0.70 | n.a | n.a |
| 34 | 200 | | | 0.41 | 0.31 | n.a | n.a |
| 35 | 20 | 1L | FeCl₃ (120 mM) | 0.29 | 0.22 | n.a | n.a |
| 36 | 200 | | | 0.12 | 0.09 | n.a | n.a |
| 37 | 20 | 3L | | 0.30 | 0.23 | n.a | n.a |
| 38 | 200 | | | 0.10 | 0.08 | n.a | n.a |
| 39 | 20 | 3L | CuCl₂ (60 mM) | 1.33 | 1.02 | n.a | n.a |
| 40 | 150 | | | 0.90 | 0.69 | n.a | n.a |
| 41 | 20 | 3L | FETOS (60 mM) | 2.56 | 1.97 | n.a | n.a |
| 42 | 150 | | | 0.59 | 0.45 | n.a | n.a |
| 43 | 20 | 3L | CuBr₂ (60 mM) | 0.43 | 0.33 | n.a | n.a |
| 44 | 150 | | | 0.06 | 0.05 | n.a | n.a |
| 45 | 20 | 3L | FeCl₃ (60 mM) | 0.36 | 0.28 | n.a | n.a |
| 46 | 150 | | | 0.13 | 0.10 | n.a | n.a |

| | | | | | | | |
|---|---|---|---|---|---|---|---|
| n.a = not available | | | | | | | |

Table 2 describes the sheet resistance and conductivity values for films comprising PAz layer(s) prepared using as the oxidant. All the films were prepared using 80 µl of oxidant solution. The oxidant was spin coated on the substrate with a spin coating speed of 2400 rpm. The oxidant layer was dried at 90 °C for 90 s. Polymerization time per layer was 4 minutes and polymerization temperature was 55 °C. Annealing was performed for all the other films except films in entries 1 to 4. In entries 5 to 8 the sheet resistance is measured before annealing step. The films were washed two times with acetonitrile and dried under nitrogen gas stream. Temperature of the deposition surface was not controlled i.e. it was at about room temperature. All the sheet resistance values are measured immediately after film preparation.

**Table 2. Sheet resistance and conductivity of values of 1L, 3L and 6L PAz films prepared with as the oxidant.**

| Entry | Layers | Oxidant | Sheet resistance (MΩ/□) | Conductivity (S/cm) | | Thickness range (nm) | |
|---|---|---|---|---|---|---|---|
| 1 | 1L | CuCl₂ (240 mM) | 14.3 | 0.04 | 0.02 | 20 | 40 |
| 2 | 3L | | 8.2 | 0.03 | 0.02 | 40 | 80 |
| 3 | 6L | | 7.4 | 0.03 | 0.01 | 45 | 110 |
| 4 | 6L | | 1.5 | 0.14 | 0.06 | 45 | 110 |
| 5 | 1L | CuCl₂ (240 mM) | 2.9 | 0.17 | 0.09 | 20 | 40 |
| 6 | 3L | | 2.5 | 0.10 | 0.05 | 40 | 80 |
| 7 | 1L | CuCl₂ (180 mM) | 3.0 | 0.25 | 0.10 | 14 | 32 |
| 8 | 3L | | 3.5 | 0.09 | 0.04 | 32 | 76 |

Table 3 describes the roughness variation of PAz films prepared with different oxidants (CuCl₂, FETOS, CuBr₂ and FeCl₃) and oxidant concentrations. All the films were prepared using 80 µl of oxidant solution. The oxidant was spin coated on the substrate with a spin coating speed of 2400 rpm. The oxidant layer was dried at 90 °C for 90 s. Polymerization time per layer was 4 minutes and polymerization temperature was 55 °C. Annealing was performed for all the other films except films in entries 1 to 3. The films were washed two times with acetonitrile and dried under nitrogen gas stream. Temperature of the deposition surface was not controlled i.e. it was at about room temperature.

**Table 3. Roughness values of 1L, 3L and 6L PAz films prepared with different oxidants.**

| Entry | Layers | Oxidant | Roughness (nm) | |
|---|---|---|---|---|
| | | | RMS | R_{avg} |
| 1 | 1L | CuCl₂ (240 mM) | 20.7 | 16.3 |
| 2 | 3L | | 20.9 | 16.1 |
| 3 | 6L | | 21.3 | 17.0 |
| 4 | 1L | CuCl₂ (240 mM) | 33.1 | 27.0 |
| 5 | 3L | | 22.1 | 17.6 |
| 6 | 1L | FETOS (240 mM) | 12.1 | 9.4 |
| 7 | 3L | | 177.0 | 145.0 |
| 8 | 1L | CuCl₂ (180 mM) | 8.3 | 5.8 |
| 9 | 3L | | 13.0 | 10.4 |
| 10 | 1L | FETOS (180 mM) | 47.2 | 31.2 |
| 11 | 3L | | 37.7 | 24.9 |
| 12 | 1L | CuCl₂ (120 mM) | 23.1 | 16.5 |
| 13 | 3L | | 27.3 | 21.1 |
| 14 | 1L | FETOS (120 mM) | 8.2 | 6.0 |
| 15 | 3L | | 0.1 | 0.1 |
| 16 | 1L | CuBr₂ (120 mM) | 6.3 | 4.0 |
| 17 | 3L | | 5.2 | 3.8 |
| 18 | 1L | FeCl₃ (120 mM) | 12.6 | 10.1 |
| 19 | 3L | | 27.6 | 21.9 |
| 20 | 3L | (60 mM) | 9.9 | 7.8 |
| 21 | | FETOS (60 mM) | 10.1 | 6.8 |
| 22 | | CuBr₂ (60 mM) | 5.0 | 2.1 |
| 23 | | FeCl₃ (60 mM) | 13.5 | 8.6 |

Table 4 describes the sheet resistance, the transmittance and roughness values for films comprising a polymer layer formed of a copolymer, wherein the monomers are PAz and PEDOT prepared by using different oxidants. Table 4 further described these values for a film comprising a PAz layer prepared without using the annealing step. All the films were prepared using 80 µl of oxidant solution. The oxidant was spin coated on the substrate with a spin coating speed of 2400 rpm. The oxidant layer was dried at 90 °C for 90 s. Polymerization time per layer was 4 minutes and polymerization temperature was 65 °C. Annealing was performed for all the other films except films in entry 3. In entries 1 and 2 the sheet resistance is measured before annealing step. The films were washed two times with acetonitrile and dried under nitrogen gas stream. The temperature of the deposition surface was 55 °C in entries 1 and 2. In entry 3, the temperature of the deposition surface was not controlled i.e. it was at about room temperature. All the sheet resistance values are measured immediately after film preparation.

**Table 4. Sheet resistance and roughness values of 1L PAz films and COPOL films prepared with different oxidants.**

| Entry | Polymer | Oxidant | Abs at 550 nm | % T at 550 nm | Sheet resistance (MΩ/□) | Roughness (nm) | |
|---|---|---|---|---|---|---|---|
| | | | | | | RMS | Rave-rage |
| 1 | COPOL (PEDOT + PAz) | CuCl₂ | 0.12 | 76 | 61 | 13 | 10 |
| 2 | COPOL (PEDOT + PAz) | FETOS (+ 120 mM Pyridine) | 0.18 | 66 | 0.05-0.2 | 44 | 34 |
| 3 | PAz | Fe (OTF)₃ | 0.10 | 80 | 0.6-1.1 | 20 | 15 |

| | | | | | | | |
|---|---|---|---|---|---|---|---|
| *number of layer in entries 1-3 was one (1L) and the oxidant concentration was 240 mM; Fe(OTF)₃ = Iron (III) trifluoromethanesulfonate | | | | | | | |

**Table 5. Electrochemical characterization of 1L COPOL (240 mM CuCl₂)**

| Potential range | Charge (mC) | Potential window (V) | Areal capacitance (mF/cm² ) | Volumetric capacitance range (F/cm³) | | Thickness range (nm) | |
|---|---|---|---|---|---|---|---|
| -0,25 to 0,8 V | 1,61 | 1,05 | 1, 4 | 428 | 1028 | | |
| -0,5 to 1,0 V | 3,69 | 1,5 | 2,2 | 687 | 1649 | | |
| -0,5 to - 1,9 V | 34, 86 | 1, 4 | 22,0 | 6951 | 16693 | 13,2 | 31,7 |

| | | | | | | | |
|---|---|---|---|---|---|---|---|
| *0.1 M TBABF₄ (tetrabutylammonium tetrafluoroborate) in Acetonitrile is used as electrolyte solution; scan rate = 50 mV/s | | | | | | | |

### Characterization

Agilent 8453 (up to 1000 nm) was used to record UV-Vis-NIR measurements (background correction was done using an uncoated substrate).

Atomic force microscopy (AFM) measurements were carried out using Veeco diCaliber scanning probe microscope operated in a tapping mode at room temperature. All AFM images were recorded using Bruker TESP-MT probe (resonant freq. 320 kHz, spring const. 42 N/m, length 125 µm, width 30 µm, Cantilever spec: 0.01-0.025 Ωcm Antimony (n) doped Silicon, 4 µm thick, tip spec: 10-15 µm height, 8 nm radius). WSXM software was used to determine mean roughness (roughness average (Ra)) values of PAz films.

CV measurements were used for electrochemical characterization. CV measurements were carried out in conventional 3 electrode configuration using 0.1M TBA-BF4/MeCN. VPP prepared PAz films on a substrate covered with different number of PAz layers were used as working electrodes. A Ag/AgCl wire and a platinum wire were used as reference and counter electrode, respectively. Ag/AgCl reference electrode was calibrated before and after every electrochemical measurement using ferrocene redox couple (E1/2 (Fe/Fe+) = 0.43 V). Cyclic voltammograms were recorded using Metrohm Autolab PGSTAT 101 potentiostat in a potential range from -0.25 V to 0.9 V with scan rates of 20 - 200 mV/s. The charge (Q) is calculated by integration of the cyclic voltammogram in the potential range -0.25 V to 0.9 V in the Origin software which is further processed by using the above presented equations (4) and (5) to obtain the capacitance values.

Jandel model RM3000+ with cylindrical four point probe head was used to calculate sheet resistance (rₛₕₑₑₜ) for 1L to 6L PAz films. The specific resistance (r) and conductivity (s) of the film was calculated from equations (6) and (7).

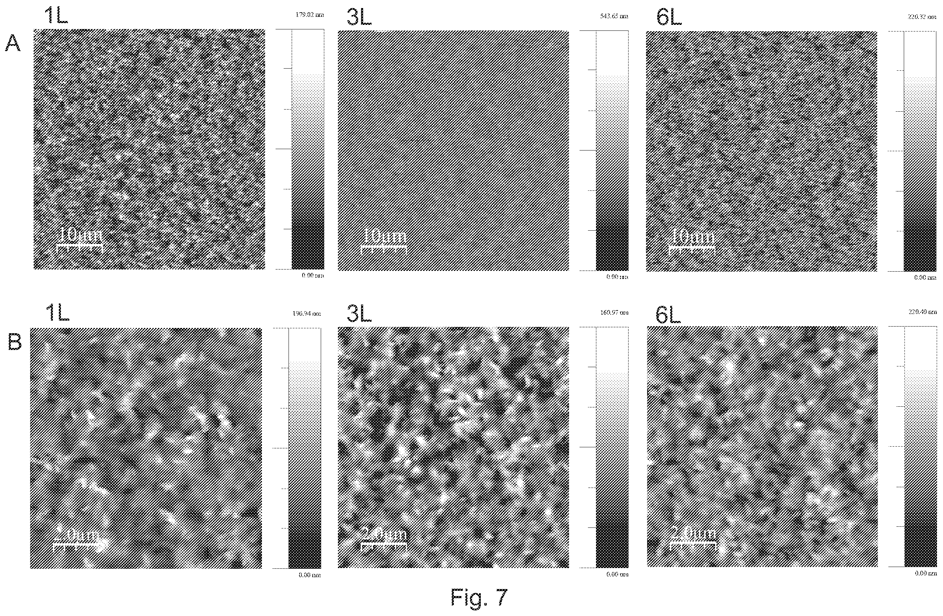

Fig. 7A illustrates AFM images of 1L, 3L and 6L PAz films with sizes of 50 by 50 µm and Fig. 7B illustrates 1L, 3L and 6L PAz films with sizes of 10 by 10 µm. All films were prepared via VPP using 80 µl of 240 mM oxidant solution. The oxidant was spin coated on the substrate with a spin coating speed of 2400 rpm. The oxidant was dried at 90°C for 90 s. Polymerization time was 4 minutes per layer and the cell temperature i.e. polymerization temperature was 55 °C. All the films were washed two times in acetonitrile and dried under nitrogen gas stream. No annealing step was used.

The embodiments described hereinbefore may be used in any combination with each other. Several of the embodiments may be combined together to form a further embodiment. A method, a film, a device, or a use disclosed herein, may comprise at least one of the embodiments described hereinbefore. It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items. The term "comprising" is used in this specification to mean including the feature(s) or act(s) followed thereafter, without excluding the presence of one or more additional features or acts.

## Claims

1. A method for fabricating a film (1) comprising at least one polymer layer (3) formed of polyazulene, or of a copolymer, wherein one of the monomers is azulene, or of any combination thereof, wherein the film is situated on at least one surface of a substrate (4), wherein the method comprises the steps of:
a) forming an oxidant layer (2) on a deposition surface by applying a solution comprising an oxidant on the deposition surface;
b) forming a polymer layer (3) formed of polyazulene, or of a copolymer, wherein one of the monomers is azulene, or of any combination thereof, by exposing the deposition surface to at least azulene monomer vapour at a polymerization temperature of 20 - 95 °C under atmospheric pressure,
wherein step a) precedes step b), and wherein, during step b), the temperature of the deposition surface differs from the polymerization temperature by 0 - 30 °C.

2. The method of claim 1, wherein the method comprises repeating step a) and step b) one or more times.

3. The method of any one of the preceding claims, wherein the polymer layer (3) is formed on the deposition surface by atmospheric pressure vapour phase polymerization (VPP).

4. The method of any one of the preceding claims, wherein step b) is continued for 1 - 20 minutes, or 2 - 16 minutes, or 4 - 8 minutes, and/or until the thickness of the polymer layer is 10 - 100 nm, or 20 - 90 nm, or 30 - 80 nm, or 40 - 60 nm.

5. The method of any one of the preceding claims, wherein in step b), the deposition surface is exposed to at least azulene monomer vapour and at least one further monomer vapour selected from a group consisting of 3,4-ethylenedioxythiophene (EDOT), pyrrole, aniline, thiophene, and phenylene.

6. The method of any one of the preceding claims, wherein the method is carried out as a batch process or a continuous process.

7. The method of any one of the preceding claims, wherein, during step b), the temperature of the deposition surface is 25 - 75 °C, or 30 - 70 °C, or 35 - 65 °C, or 40 - 50 °C, or 45 - 55 °C, and the polymerization temperature is 25 - 90 °C, or 35 - 85 °C, or 40 - 80 °C, or 45 - 75 °C, or 50 - 60 °C, or 55 - 65 °C.

8. The method of any one of the preceding claims, wherein, during step b), the temperature of the deposition surface is 0 - 30 °C, or 1 - 25 °C, or 5 - 20 °C, or 10 - 15 °C, lower than the polymerization temperature or 0 - 20 °C, or 1 - 15 °C, or 5 - 10 °C, higher than the polymerization temperature.

9. The method of any one of the preceding claims, wherein the oxidant is selected from a group consisting of FETOS, FeCl₃, CuCl₂, CuBr₂, and Fe(OTf)₃, and the concentration of the solution comprising the oxidant is 60 - 500 mM, or 70 - 480 mM, or 120 - 320 mM, or 180 - 240 mM.

10. The method of any one of the preceding claims, wherein the solution comprising the oxidant is spin coated on the deposition surface.

11. The method of any one of the preceding claims, wherein the method comprises, after step b), the step of annealing the film at a temperature of 60 - 100 °C.

12. A film (1) comprising at least one polymer layer (3) formed of polyazulene, or of a copolymer, wherein one of the monomers is azulene, or of any combination thereof, wherein the film is situated on at least one surface of a substrate (4), wherein the total thickness of the film is 10 nm - 100 µm, the average roughness of the film is below 200 nm, and the sheet resistance of the film is 1 - 80 MΩ/□.

13. A film (1) comprising at least one polymer layer (3) formed of polyazulene, or of a copolymer, wherein one of the monomers is azulene, or of any combination thereof, wherein the film is situated on at least one surface of a substrate (4) obtainable by the method of any one of claims 1-11, wherein the average roughness of the film is below 200 nm and the sheet resistance of the film is 1 - 80 MΩ/□.

14. The film of claim 12 or 13, wherein the total thickness of the film is 20 nm - 50 µm, or 50 nm - 10 µm, or 100 nm - 1 µm, or 200 nm - 500 nm.

15. The film of any one of claims 12 - 14, wherein the film is conductive.

16. The film of any one of claims 12 - 15, wherein the average roughness of the film is below 150 nm, or below 100 nm, or below 80 nm, or below 50 nm, or below 25 nm, or below 15 nm, or below 10 nm, the areal capacitance of the film is 0 - 10 mF/cm², or 0.01 - 9 mF/cm², or 0.05 - 8 mF/cm², or 0.2 - 7 mF/cm², or 1 - 5 mF/cm², or 2 - 4 mF/cm², the volumetric capacitance is 200 - 2000 F/cm³, or 250 - 1500 F/cm³, or 300 - 1200 F/cm³, or 500 - 1000 F/cm³, or 600 - 800 F/cm³, the transmittance of the film is 10 - 95%, or 20 - 85%, or 30 - 75%, the sheet resistance of the film is 2 - 70 MΩ/□, or 5 - 50 MΩ/□, or 10 - 40 MΩ/□, or 15 - 30 MΩ/□, and the conductivity of the film is 0 - 3 S.cm, or 0.01 - 2 S.cm, or 0.05 - 1.5 S.cm, or 0.1 - 1.0 S.cm, or 0.3 - 0.8 S.cm, or 0.4 - 0.6 S.cm.

17. A device comprising a film (1) as defined in any one of claims 12 - 16.

18. The device of claim 17, wherein the device is an organic electrochemical transistor, an electrochemical transducer, an electrochromic device, an electroluminescent device, an electroluminescent display, an organic capacitor, a supercapacitor, a sensor, a biosensor, an energy harvesting device, an antistatic material, a photovoltaic device, a storage device or a thermoelectric device.

19. Use of the film as defined in any one of claims 12 - 16 as an antistatic coating or an electrode in/of an electronic device.

20. A system for fabricating a film (1) comprising at least one polymer layer (3) formed of polyazulene, or of a copolymer, wherein one of the monomers is azulene, or of any combination thereof, wherein the film is situated on at least one surface of a substrate (4), wherein the system comprises:
a) an oxidant unit (12) configured to apply a solution comprising an oxidant on a deposition surface for forming an oxidant layer (2) on the deposition surface; and
b) a chamber (5) configured to expose the deposition surface to at least azulene monomer vapour at a polymerization temperature of 25 - 95 °C under atmospheric pressure for forming a polymer layer (3) formed of polyazulene, or of a copolymer, wherein one of the monomers is azulene, or of any combination thereof,
wherein the oxidant unit precedes the chamber, and wherein, in the chamber, the temperature of the deposition surface is configured to differ from the polymerization temperature by 0 - 30 °C.

## Patentansprüche

1. Verfahren zur Herstellung eines Films (1), umfassend mindestens eine Polymerschicht (3), die aus Polyazulen, oder aus einem Copolymer, wobei eines der Monomere Azulen ist, oder aus einer beliebigen Kombination davon gebildet ist, wobei der Film auf mindestens einer Oberfläche eines Substrats (4) angeordnet ist, wobei das Verfahren die folgenden Schritte umfasst:
a) Bilden einer Oxidationsmittelschicht (2) auf einer Abscheidungsoberfläche durch Aufbringen einer Lösung, die ein Oxidationsmittel umfasst, auf die Abscheidungsoberfläche;
b) Bilden einer Polymerschicht (3), die aus Polyazulen, oder aus einem Copolymer, wobei eines der Monomere Azulen ist, oder aus einer beliebigen Kombination davon gebildet ist, indem die Abscheidungsoberfläche bei einer Polymerisationstemperatur von 20 - 95 °C unter Atmosphärendruck mindestens Azulen-Monomerdampf ausgesetzt wird,
wobei Schritt a) dem Schritt b) vorausgeht, und wobei sich während Schritt b) die Temperatur der Abscheidungsoberfläche von der Polymerisationstemperatur um 0 - 30 °C unterscheidet.

2. Verfahren nach Anspruch 1, wobei das Verfahren das ein- oder mehrmalige Wiederholen von Schritt a) und Schritt b) umfasst.

3. Verfahren nach einem der vorhergehenden Ansprüche, wobei die Polymerschicht (3) auf der Abscheidungsoberfläche durch Atmosphärendruck-Dampfphasenpolymerisation (VPP) gebildet wird.

4. Verfahren nach einem der vorhergehenden Ansprüche, wobei Schritt b) für 1 - 20 Minuten, oder 2 - 16 Minuten, oder 4 - 8 Minuten fortgesetzt wird, und/oder bis die Dicke der Polymerschicht 10 - 100 nm, oder 20 - 90 nm, oder 30 - 80 nm, oder 40 - 60 nm beträgt.

5. Verfahren nach einem der vorhergehenden Ansprüche, wobei in Schritt b) die Abscheidungsoberfläche mindestens Azulen-Monomerdampf und mindestens einem weiteren Monomerdampf ausgesetzt wird, der aus einer Gruppe ausgewählt ist, bestehend aus 3,4-Ethylendioxythiophen (EDOT), Pyrrol, Anilin, Thiophen und Phenylen.

6. Verfahren nach einem der vorhergehenden Ansprüche, wobei das Verfahren als Chargenprozess oder als kontinuierlicher Prozess durchgeführt wird.

7. Verfahren nach einem der vorhergehenden Ansprüche, wobei während Schritt b) die Temperatur der Abscheidungsoberfläche 25 - 75 °C, oder 30 - 70 °C, oder 35 - 65 °C, oder 40 - 50 °C, oder 45 - 55 °C beträgt, und die Polymerisationstemperatur 25 - 90 °C, oder 35 - 85 °C, oder 40 - 80 °C, oder 45 - 75 °C, oder 50 - 60 °C, oder 55 - 65 °C beträgt.

8. Verfahren nach einem der vorhergehenden Ansprüche, wobei während Schritt b) die Temperatur der Abscheidungsoberfläche 0 - 30 °C, oder 1 - 25 °C, oder 5 - 20 °C, oder 10 - 15 °C niedriger als die Polymerisationstemperatur ist oder 0 - 20 °C, oder 1 - 15 °C, oder 5 - 10 °C höher als die Polymerisationstemperatur ist.

9. Verfahren nach einem der vorhergehenden Ansprüche, wobei das Oxidationsmittel aus einer Gruppe ausgewählt ist, bestehend aus FETOS, FeCl₃, CuCl₂, CuBr₂ und Fe(OTf)₃, und die Konzentration der Lösung, die das Oxidationsmittel umfasst, 60 - 500 mM, oder 70 - 480 mM, oder 120 - 320 mM, oder 180 - 240 mM beträgt.

10. Verfahren nach einem der vorhergehenden Ansprüche, wobei die Lösung, die das Oxidationsmittel umfasst, auf die Abscheidungsoberfläche rotationsbeschichtet wird.

11. Verfahren nach einem der vorhergehenden Ansprüche, wobei das Verfahren nach Schritt b) den Schritt des Temperns des Films bei einer Temperatur von 60 - 100 °C umfasst.

12. Film (1), umfassend mindestens eine Polymerschicht (3), die aus Polyazulen, oder aus einem Copolymer, wobei eines der Monomere Azulen ist, oder aus einer beliebigen Kombination davon gebildet ist, wobei der Film auf mindestens einer Oberfläche eines Substrats (4) angeordnet ist, wobei die Gesamtdicke des Films 10 nm - 100 µm beträgt, die durchschnittliche Rauheit des Films unter 200 nm liegt, und der Schichtwiderstand des Films 1 - 80 MΩ/□ beträgt.

13. Film (1), umfassend mindestens eine Polymerschicht (3), die aus Polyazulen, oder aus einem Copolymer, wobei eines der Monomere Azulen ist, oder aus einer beliebigen Kombination davon gebildet ist, wobei der Film auf mindestens einer Oberfläche eines Substrats (4) angeordnet ist, der durch das Verfahren nach einem der Ansprüche 1 - 11 erhalten werden kann, wobei die durchschnittliche Rauheit des Films unter 200 nm liegt und der Schichtwiderstand des Films 1 - 80 MΩ/□ beträgt.

14. Film nach Anspruch 12 oder 13, wobei die Gesamtdicke des Films 20 nm - 50 µm, oder 50 nm - 10 µm, oder 100 nm - 1 µm, oder 200 nm - 500 nm beträgt.

15. Film nach einem der Ansprüche 12 - 14, wobei der Film leitfähig ist.

16. Film nach einem der Ansprüche 12 - 15, wobei die durchschnittliche Rauheit des Films unter 150 nm, oder unter 100 nm, oder unter 80 nm, oder unter 50 nm, oder unter 25 nm, oder unter 15 nm, oder unter 10 nm liegt, die Flächenkapazität des Films 0 - 10 mF/cm², oder 0,01 - 9 mF/cm², oder 0,05 - 8 mF/cm², oder 0,2 - 7 mF/cm², oder 1 - 5 mF/cm², oder 2 - 4 mF/cm² beträgt, die Volumenkapazität 200 - 2000 F/cm³, oder 250 - 1500 F/cm³, oder 300 - 1200 F/cm³, oder 500 - 1000 F/cm³, oder 600 - 800 F/cm³ beträgt, der Transmissionsgrad des Films 10 - 95 %, oder 20 - 85 %, oder 30 - 75 % beträgt, der Schichtwiderstand des Films 2 - 70 MΩ/□, oder 5 - 50 MΩ/□, oder 10 - 40 MΩ/□, oder 15 - 30 MΩ/□ beträgt, und die Leitfähigkeit des Films 0 - 3 S/cm, oder 0,01 - 2 S/cm, oder 0,05 - 1,5 S/cm, oder 0,1 - 1,0 S/cm, oder 0,3 - 0,8 S/cm, oder 0,4 - 0,6 S/cm beträgt.

17. Vorrichtung, die einen Film (1) gemäß einem der Ansprüche 12 - 16 umfasst.

18. Vorrichtung nach Anspruch 17, wobei die Vorrichtung ein organischer elektrochemischer Transistor, ein elektrochemischer Wandler, eine elektrochrome Vorrichtung, eine elektrolumineszente Vorrichtung, eine Elektrolumineszenzanzeige, ein organischer Kondensator, ein Superkondensator, ein Sensor, ein Biosensor, eine Energiegewinnungsvorrichtung, ein antistatisches Material, eine photovoltaische Vorrichtung, eine Speichervorrichtung oder eine thermoelektrische Vorrichtung ist.

19. Verwendung des Films, wie in einem der Ansprüche 12 - 16 definiert, als antistatische Beschichtung oder als Elektrode in/von einer elektronischen Vorrichtung.

20. System zur Herstellung eines Films (1), umfassend mindestens eine Polymerschicht (3), die aus Polyazulen, oder aus einem Copolymer, wobei eines der Monomere Azulen ist, oder aus einer beliebigen Kombination davon gebildet ist, wobei der Film auf mindestens einer Oberfläche eines Substrats (4) angeordnet ist, wobei das System umfasst:
a) eine Oxidationsmitteleinheit (12), die dazu konfiguriert ist, eine Lösung, die ein Oxidationsmittel umfasst, auf eine Abscheidungsoberfläche aufzubringen, um eine Oxidationsmittelschicht (2) auf der Abscheidungsoberfläche zu bilden; und
b) eine Kammer (5), die dazu konfiguriert ist, die Abscheidungsoberfläche bei einer Polymerisationstemperatur von 25 - 95 °C unter Atmosphärendruck mindestens Azulen-Monomerdampf auszusetzen, um eine Polymerschicht (3) zu bilden, die aus Polyazulen, oder aus einem Copolymer, wobei eines der Monomere Azulen ist, oder aus einer beliebigen Kombination davon gebildet ist,
wobei die Oxidationsmitteleinheit der Kammer vorgelagert ist, und wobei in der Kammer die Temperatur der Abscheidungsoberfläche dazu konfiguriert ist, sich von der Polymerisationstemperatur um 0 - 30 °C zu unterscheiden.

## Revendications

1. Procédé pour la fabrication d'un film (1) comprenant au moins une couche polymère (3) formée de polyazulène ou d'un copolymère, dans lequel l'un des monomères est l'azulène, ou de toute combinaison de ceux-ci, dans lequel le film est situé sur au moins une surface d'un substrat (4), le procédé comprenant les étapes suivantes :
a) formation d'une couche d'oxydant (2) sur une surface de dépôt, par application sur la surface de dépôt d'une solution comprenant un oxydant ;
b) formation d'une couche polymère (3) formée de polyazulène, ou d'un copolymère, dans lequel l'un des monomères est l'azulène, ou de toute combinaison de ceux-ci, par exposition de la surface de dépôt au moins une vapeur de monomère d'azulène à une température de polymérisation allant de 20 à 95 °C sous pression atmosphérique,
dans lequel l'étape a) précède l'étape b), et dans lequel, pendant l'étape b), la température de la surface de dépôt diffère de la température de polymérisation d'une valeur allant de 0 à 30 °C.

2. Procédé selon la revendication 1, le procédé comprenant la répétition de l'étape a) et de l'étape b) une ou plusieurs fois.

3. Procédé selon l'une quelconque des revendications précédentes, dans lequel la couche polymère (3) est formée sur la surface de dépôt par polymérisation en phase vapeur à pression atmosphérique (VPP).

4. Procédé selon l'une quelconque des revendications précédentes, dans lequel l'étape b) est poursuivie pendant 1 à 20 minutes, ou 2 à 16 minutes, ou 4 à 8 minutes, et/ou jusqu' ce que l'épaisseur de la couche polymère soit de 10 à 100 nm, ou de 20 à 90 nm, ou de 30 à 80 nm, ou de 40 à 60 nm.

5. Procédé selon l'une quelconque des revendications précédentes, dans lequel, à l'étape b), la surface de dépôt est exposée à au moins une vapeur de monomère d'azulène et à au moins une autre vapeur de monomère sélectionnée dans un groupe consistant en le 3, 4-éthylènedioxythiophène (EDOT), le pyrrole, l'aniline, le thiophène, et le phénylène.

6. Procédé selon l'une quelconque des revendications précédentes, dans lequel le procédé est mis en œuvre en tant que procédé par lots ou procédé continu.

7. Procédé selon l'une quelconque des revendications précédentes, dans lequel, pendant l'étape b), la température de la surface de dépôt va de 25 à 75 °C, ou de 30 à 70 °C, ou de 35 à 65 °C, ou de 40 à 50 °C, ou de 45 à 55 °C, et la température de polymérisation va de 25 à 90 °C, ou de 35 à 85 °C, ou de 40 à 80 °C, ou de 45 à 75 °C, ou de 50 à 60 °C, ou de 55 à 65 °C.

8. Procédé selon l'une quelconque des revendications précédentes, dans lequel, pendant l'étape b), la température de la surface de dépôt est de 0 à 30 °C, ou de 1 à 25 °C, ou de 5 à 20 °C, ou de 10 à 15 °C, inférieure à la température de polymérisation ou est de 0 à 20 °C, ou de 1 à 15 °C, ou de 5 à 10 °C supérieure la température de polymérisation.

9. Procédé selon l'une quelconque des revendications précédentes, dans lequel l'oxydant est sélectionné dans un groupe consistant en FETOS, FeCl₃, CuCl₂, CuBr₂, et Fe (OTf)₃, et la concentration de la solution comprenant l'oxydant va de 60 à 500 mM, ou de 70 à 480 mM, ou de 120 à 320 mM, ou de 180 à 240 mM.

10. Procédé selon l'une quelconque des revendications précédentes, dans lequel la solution comprenant un oxydant est déposée par centrifugation sur la surface de dépôt.

11. Procédé selon l'une quelconque des revendications précédentes, dans lequel le procédé comprend, après l'étape b), l'étape de recuit du film une température allant de 60 à 100 °C.

12. Film (1) comprenant au moins une couche polymère (3) formée de polyazulène, ou d'un copolymère, dans lequel l'un des monomères est l'azulène, ou de toute combinaison de ceux-ci, dans lequel le film est situé sur au moins une surface d'un substrat (4), dans lequel l'épaisseur totale du film va de 10 nm - 100 µm, la rugosité moyenne du film est inférieure à 200 nm, et la résistance surfacique du film va de 1 à 80 MΩ/□.

13. Film (1) comprenant au moins une couche polymère (3) formée de polyazulène, ou d'un copolymère, dans lequel l'un des monomères est l'azulène, ou de toute combinaison de ceux-ci, dans lequel le film est situé sur au moins une surface d'un substrat (4) apte à être obtenu par le procédé selon l'une quelconque des revendications 1 à 11, dans lequel la rugosité moyenne du film est inférieure à 200 nm et la résistance surfacique du film est de 1 à 80 MΩ/□.

14. Film selon la revendication 12 ou la revendication 13, dans lequel l'épaisseur totale du film est de 20 nm à 50 µm, ou de 50 nm à 10 µm, ou de 100 nm à 1 µm, ou de 200 nm à 500 nm.

15. Film selon l'une quelconque des revendications 12 à 14, dans lequel le film est conducteur.

16. Film selon l'une quelconque des revendications 12 à 15, dans lequel la rugosité moyenne du film est inférieure à 150 nm, ou inférieure à 100 nm, ou inférieure à 80 nm, ou inférieure à 50 nm, ou inférieure à 25 nm, ou inférieure à 15 nm, ou inférieure à 10 nm, la capacité surfacique du film est de 0 à 10 mF/cm², ou de 0,01 à 9 mF/cm², ou de 0,05 à 8 mF/cm², ou de 0,2 à 7 mF/cm², ou de 1 à 5 mF/cm², ou de 2 à 4 mF/cm², la capacité volumique est de 200 à 2000 F/cm³, ou de 250 à 1500 F/cm³, ou de 300 à 1200 F/cm³, ou de 500 à 1000 F/cm³, ou de 600 à 800 F/cm³, la transmittance du film est de 10 à 95 %, ou de 20 à 85 %, ou de 30 à 75 %, la résistance surfacique du film est de 2 à 70 MΩ/□, ou de 5 à 50 MΩ/□, ou de 10 à 40 MΩ/□, ou de 15 à 30 MΩ/□, et la conductivité du film est de 0 à 3 S.cm, ou de 0,01 à 2 S.cm, ou 0,05 à 1,5 S.cm, ou de 0,1 à 1,0 S.cm, ou de 0,3 à 0,8 S.cm, ou de 0,4 à 0,6 S.cm.

17. Dispositif comprenant un film (1) tel que défini dans l'une quelconque des revendications 12 à 16.

18. Dispositif selon la revendication 17, dans lequel le dispositif est un transistor électrochimique organique, un transducteur électrochimique, un dispositif électrochrome, un dispositif électroluminescent, un affichage électroluminescent, un condensateur organique, un supercondensateur, un capteur, un biocapteur, un dispositif de récupération d'énergie, un matériau antistatique, un dispositif photovoltaïque, un dispositif de stockage ou un dispositif thermoélectrique.

19. Utilisation du film tel que défini dans l'une quelconque des revendications 12 à 16 en tant que revêtement antistatique ou électrode dans un / d'un dispositif électronique.

20. Système pour la fabrication d'un film (1) comprenant au moins une couche polymère (3) formée de polyazulène, ou d'un copolymère, dans lequel l'un des monomères est l'azulène, ou de toute combinaison de ceux-ci, dans lequel le film est situé sur au moins une surface d'un substrat (4), dans lequel le système comprend :
a) une unité d'oxydant (12) configurée pour appliquer une solution comprenant un oxydant sur une surface de dépôt, de manière à former une couche d'oxydant (2) sur la surface de dépôt ; et
b) une chambre (5) configurée pour exposer la surface de dépôt à au moins une vapeur de monomère d'azulène à une température de polymérisation allant de 25 à 95 °C sous pression atmosphérique afin de former une couche polymère (3) formée de polyazulène, ou d'un copolymère, dans lequel l'un des monomères est l'azulène, ou de toute combinaison de ceux-ci,
dans lequel l'unité d'oxydant précède la chambre, et dans lequel, dans la chambre, la température de la surface de dépôt est configurée pour différer de la température de polymérisation, d'une valeur allant de 0 à 30 °C.
